**Europäisches Patentamt**

(19) **European Patent Office**

**Office européen des brevets**

(11) Numéro de publication: **0 117 789**

**B1**

(12) # FASCICULE DE BREVET EUROPÉEN

(45) Date de publication du fascicule du brevet:
02.09.87

(51) Int. Cl.⁴: **H 03 K 5/153**, F 02 P 7/06

(21) Numéro de dépôt: **84400213.9**

(22) Date de dépôt: **31.01.84**

(54) **Montage d'exploitation de signaux électriques fournis par un capteur à réluctance variable.**

(30) Priorité: **24.02.83 FR 8303015**

(43) Date de publication de la demande:
**05.09.84 Bulletin 84/36**

(45) Mention de la délivrance du brevet:
**02.09.87 Bulletin 87/36**

(84) Etats contractants désignés:
**AT DE GB IT**

(56) Documents cité:
**FR-A-2 404 256**
**US-A-3 753 109**
**US-A-3 767 938**
**US-A-3 944 936**

(73) Titulaire: **AUTOMOBILES PEUGEOT, Société dite:, 75, Avenue de la Grande- Armée, F-75761 Paris Cedex 16 (FR)**
Titulaire: **AUTOMOBILES CITROEN, 62 Boulevard Victor- Hugo, F-92200 Neuilly- sur- Seine (FR)**

(72) Inventeur: **Bosc, Jean- Jacques, 7, rue Frédéric Chopin Rés. "Les Peupliers", F-91380 Chilly- Mazarin (FR)**

(74) Mandataire: **Fabien, Henri, PEUGEOT SA. DAT / BPI 18, rue des Fauvelles, F-92250 La Garenne- Colombes (FR)**

## Description

L'invention a pour objet un montage d'exploitation des signaux électriques fournis par un capteur à réluctance variable, comprenant un étage d'entrée traitant des signaux issus d'un capteur et ayant une amplitude fonction de la vitesse de rotation d'une pièce ou cible, par exemple portée par un arbre rotatif tel que vilebrequin d'un moteur à combustion interne, un étage de mise en forme de signaux et un étage de sortie.

Dans ce type de montage, on recherche une grande sensibilité de l'étage d'entrée, comme c'est le cas dans la demande de brevet français FR-A-2 538 635 déposée le 23.12.1982 par les demanderesses et publiée le 29.06.1984, cette recherche d'une grande sensibilité de l'étage d'entrée augmente considérablement le risque de détecter des cibles parasites, c'est-à-dire tout décrochement métallique, aspérité, tête de vis, passage d'un métal à un autre, tout ce qui est susceptible de créer une modification de flux introduisant dans le dispositif des, impulsions parasites.

L'invention a pour but d'éliminer les impulsions parasites. On connait des montages d'exploitation de signaux électriques fournis par deux capteurs inductifs qui sont pourvus d'un dispositif destiné à éliminer les impulsions parasites dont l'amplitude dépend de la vitesse, tel que le montage décrit dans le document FR-A-2 447 553.

Dans ce montage des impulsions de tension sont générées par passage devant une bobine d'induction de dents portées par un disque indicateur.

Le disque est muni en outre d'un repère défilant devant une bobine de repérage et générant des impulsions de repérage dont l'amplitude croît ou décroît suivant que la vitesse croît ou décroît.

Pour identifier correctement ces impulsions de repérage, même lorsque des impulsions parasites sont diffusées, le circuit d'exploitation contient un comparateur dont l'entrée non inversante est raccordée à un condensateur et à une première resistance par une autre résistance. La bobine générant les impulsions de tension charge le condensateur par l'intermédiaire d'une diode. La première résistance effectue alors une décharge permanente du condensateur ondulant la tension servant de seuil.

Dans le comparateur sont comparées la tension de seuil $V_c$ et la tension de repérage $U_m$, et tant que cette dernière sera supérieure à $V_c$ la sortie du comparateur sera à zéro. Le franchissement vers le bas de $V_c$ déclenchera un multivibrateur monostable qui délivrera une impulsion de repérage. Celle-ci ne commence donc pas lors du passage à zéro de la tension de repérage, mais la précède de TF.

Ce dispositif nécessite donc deux capteurs et l'instant de détection fixé par coincidence du signal utile et de la tension de seuil apporte les inconvénients suivants:
- erreurs à bas régime résultant de l'ondulation du signal déterminant le seuil,
- présence d'erreurs de détection en régime transitoire du fait du traînage du seuil (les amplitudes du 1er capteur répondent instantanément aux variations de régime, tandis que le seuil possède un temps de réponse),
- l'instant de détection lié aux amplitudes relatives de deux capteurs provoque un cumul des erreurs dues aux dispersions d'entre fer (erreurs importantes, l'amplitude du signal étant une fonction inversement proportionnelle au carré de l'entre fer).

Un montage d'exploitation de signaux conforme à la présente invention a pour but de remédier aux défauts ci-dessus énumérés et ne nécessite pas l'utilisation de deux capteurs.

Un tel montage comporte un étage d'entrée à haute sensibilité traitant des signaux issus du capteur et ayant une amplitude fonction de la vitesse de rotation d'une pièce ou cible portée par exemple par un arbre rotatif, tel que le vilebrequin d'un moteur à combustion interne, un étage de mise en forme des sigaux comportant un comparateur et un étage de sortie, et un dispositif d'inhibitiondisposé parallèlement à l'étage de mise en forme des signaux mémorisant initialement une fraction de la valeur maximale du signal d'entrée et ne validant la sortie que pour les signaux de valeur maximale supérieure à la valeur mémorisée et mémorisant alors une nouvelle valeur de l'amplitude maximum.

Le brevet US-A-3 767 938 décrit un montage de ce type dans lequel le signal est traité en tension, la validation de la sortie et la mémorisation à, une nouvelle valeur s'effectuant l'une et l'autre sur l'alternance qui précède le passage à zéro.

Le document FR-A-2 404 256 n'a pas pour objet un dispositif d'inhibition disposé parallèlement à un étage de mise en forme des signaux. Il décrit un dispositif de détection d'un signal délivré par un capteur magétique en comparamt, après un passage à zéro, la tension du sigal avec une fraction mémorisée de la tension atteinte après la détection précédente. Un tel dispositif ne permet donc pas la détection précise du passage à zéro.

Dans l'un et l'autre de ces documents la même alternance du sigal est utilisée pour la comparaison et pour la mémorisation, le traitement s'effectuant en tension.

Un montage d'exploitation conforme à l'invention se caractérise en ce que les moyens qui permettent au dispositif d'inhibition 20 de reconnaitre les signaux utiles et de valider l'information souhaitée comprennent
- un premier moyen 21 qui fournit au dispositif d'inhibition l'image des courants d'entrée de l'étage d'entrée du montage d'exploitation et élimine les courants de polarisation et les courants parasites en mode commun,
- un deuxième moyen C, recevant le signal de sortie du premier moyen et mémorisant la valeur maximum atteinte par l'amplitude de la deuxième alternance du sigal d'entrée,

- un troisième moyen 22 déterminant une fraction K de la valeur mémorisée et l'injectant à une entrée d'un quatrième moyen,

- un quatrième moyen 23 déterminant par comparaison si les amplitudes suivantes ont atteint ou non la fraction K de la valeur mémorisée et délivrant ou non un courant de remise à zéro du moyen de mémorisation, ce dernier mémorisant ou non une nouvelle valeur de l'amplitude maximum,

- un cinquième moyen de commande 24, qui en fonction de la valeur mémorisée et de l'état logique de l'entrée de l'étage de sortie du montage d'exploitation, autorise ou non la sortie de l'information désirée par action sur l'entre 18 du comparateur 15.

De cette façon l'instant de détection ou la position angulaire choisis comme référence peuvent être le passage à zéro.

D'autres caractéristiques et avantages de l'information seront mieux compris à l'aide de la description détaillée ci-dessous d'un exemple de réalisation en référence aux dessins annexés sur lesquels:

La figure 1 est un schéma synoptique d'un montage d'exploitation de sigaux 10 comportant un dispositif d'inhibition 20 selon l'invention.

La figure 2 est un schéma synoptique du dispositif d'inhibition 20.

La figure 3 est un exemple détaillé du dispositif d'inhibition 20.

La figure 4 est un chronogramme montrant la relation entre les signaux d'entrée, la tension du moyen de mémorisation et le sigal de sortie.

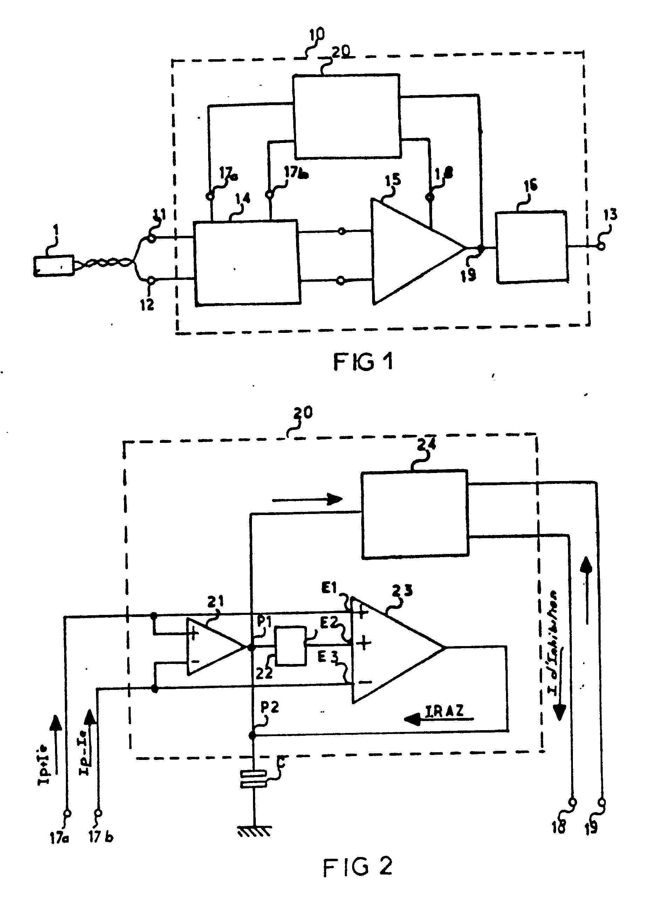

Sur la figure 1, un montage d'exploitation de signaux 10, raccordé par ses entrées 11 et 12 à un capteur 1 et délivrant des signaux d'exploitation sur sa sortie 13, comprend de façon classique un étage d'entrée 14 à haute sensibilité, un comparateur 15 et un étage de sortie 16.

Le montage 10 comprend en outre et conformément à l'invention un dispositif d'inhibition 20 connecté en 17a et 17b à l'étage d'entrée, en 18 à une commande d'inhibition du comparateur 15 et en 19 à un point de détection de l'état logique de la sortie du comparateur 15.

Le dispositif d'inhibition 20 de la figure 2 reçoit en 17a, 17b l'image des signaux capteurs utilisés dans l'étage d'entrée 14 (fig. 1) étage du type décrit dans la demande de brevet français FR-A-2 538 635 déposée par les demanderesses. Sur ces entrées est connecté un moyen 21 comprenant notamment un comparateur dont la sortie est liée au point P1. Ce moyen 21 élimine les courants de polarisation et délivre sur sa sortie en P1 un courant double du courant d'entrée. Le point P1 est relié d'une part à un moyen 24 et d'autre part à un moyen de mémorisation comprenant notamment un condensateur C. P1 est aussi lié à l'entrée d'un moyen 22 déterminant une fraction K du courant mémorisé par le condensateur C, cette fraction est délivrée à une entrée positive E2 d'un moyen 23.

Le moyen 23 reçoit sur son entrée E1 reliée à l'entrée 17a et sur son entrée E3 reliée à l'entrée 17b du dispositif 20, l'image des signaux capteurs utilisés dans l'étage d'entrée 14 (fig.1).

Le point P1 est en outre relié, d'une part à l'une des bornes du condensateur C, lequel a son autre borne reliée à la masse, d'autre part à une entrée d'un dispositif de commande d'inhibition 24. Ce dernier reçoit de la prise 19 l'information de l'état logique de la sortie du comparateur 15. Cette information, transmise au dispositif 24 avec la valeur du courant mémorisé, permet à ce dernier en fonction des valeurs de ces deux informations de délivrer ou non à l'entrée 18 du comparateur 15 un courant d'inhibition.

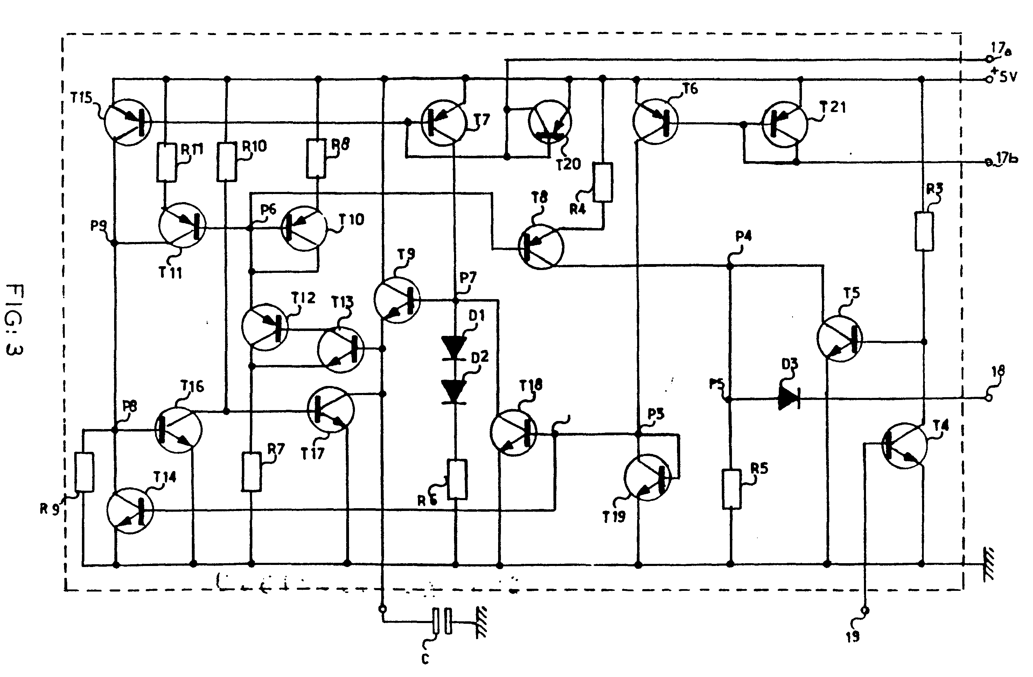

On va maintenant décrire en référence à la figure 3 un exemple de réalisation du dispositif d'inhibition 20. L'information permettant au dispositif 20 d'élaborer les images des courants d'entrée est reçue aux bornes 17a, 17b. L'état logique de la sortie du comparateur 15 est reçu à la borne 19. Le moyen de mémorisation est constitué du condensateur relié d'une part à la ligne commune à l'émetteur d'un transistor T9, à la base d'un transistor T13 et au collecteur d'un transistor T17 et d'autre part à la masse.

La résistance R3 liée par une de ses extrémités à l'alimentation + 5V a son autre extrémité reliée d'une part à la base du transistor T5 qu'elle polarise et d'autre part au collecteur d'un transistor T4. La base de T4 est reliée à l'entrée 19, l'émetteur de T4 est relié à la masse. L'émetteur de T5 est en liaison avec la masse et son collecteur est relié d'une part avec le collecteur d'un transistor T8 et l'autre part avec un point R5 relié d'une part à la masse par la résistance P5 et d'autre part à l'anode d'une diode D3 dont la cathode est reliée à la sortie 18. L'émetteur du transistor T8 est lié à l'alimentation + 5V via la résistance R4. La base de T8 est reliée au point P6, situé sur la ligne reliant les bases de deux transistors T10, T11. L'émetteur du transistor T7 est lié à l'alimentation + 5V. La base de T7 est couplée à celle d'un transistor T15 d'une part et à la base d'un transistor T20 d'autre part.

Le transistor T20 est monté en diode, son émetteur est lié à la ligne + 5V et son collecteur à l'entrée 17a.

Les transistors T7 et T20 forment ainsi un miroir de courant.

Le collecteur de T7 est relié à un point P7, liant la base d'un transistor T9 au collecteur d'un transistor T18. 2 Le point P7 est lié aussi à l'anode d'une diode D1 en série avec une diode D2 et une résistance R6 reliée à la masse.

La base du transistor T18 est liée au point P3 situé sur la ligne des collecteurs des transistors T6, T19. La base de T18 est également couplée avec la base d'un transistor T14. L'émetteur de T18 est relié à la masse.

Le collecteur du transistor T9 est lié à l'alimentation + 5V, l'émetteur de T9 est lié au condensateur C, au collecteur d'un transistor T17 et à la base d'un transistor T13. Le transistor T13 est monté en faux Darlington avec un transistor T12, dont le collecteur est lié à la masse par la résistance R7 et l'émetteur au point P6, situé sur la ligne joignant les bases des transistors T10, T11.

L'émetteur de T11 est lié à l'alimentation + 5V par une résistance R11. Le collecteur de T11 est relié au point P9 sur la ligne de liaison des collecteurs des transistors T15, T14.

L'émetteur du transistor T10, monté en diode, est relié à l'alimentation + 5V par une résistance R8. Les transistors T10 et T11 forment ainsi un miroir de courant. Le transistor T 15, couplé par son collecteur au transistor T14, est lié par son émetteur à la ligne + 5V. La base de T15 est liée aux bases des transistors T7 et T20. Le transistor T20, monté en diode, forme avec T15 un miroir de courant.

L'émetteur du transistor T14 est lié d'une part à la masse et d'autre part à un point P8 situé sur la lignie joignant les collecteurs de T15 et T14 par la résistance R9. La base de T14 est liée à la ligne joignant les bases des transistors T18, T19.

La base du transistor T16 est liée au point P8. L'émetteur de T16 est lié à la masse, le collecteur de T16 est lié d'une part à l'alimentation + 5V par une résistance R10 et d'autre part à la base d'un transistor T17. L'émetteur du transistor T17 est lié à la masse. Le collecteur de T17 est lié à la ligne reliant l'émetteur du transistor T9 à une des bornes du condensateur C. L'émetteur du transistor T19, monté en diode, est lie à la masse. Le collecteur de T19 est lié en P3 d'une part à la base de T18 et d'autre part au collecteur d'un transistor T6. L'émetteur de T6 est lié à l'alimentation + 5V. La base de T6 est liée à la base d'un transistor T21, monté en diode. L'émetteur de T21 est lié à l'alimentation + 5V et le collecteur de T21 est lié à l'entrée 17b. Les transistors T6 et T21 forment un miroir de courant.

Le fonctionnement du dispositif est donc le suivant: les entrées 17a, 17b du dispositif 20 reçoivent de l'étage d'entrée 14 du montage d'exploitation de signaux 10 (voir fig. 1) les images de la variable d'entrée du courant capteur en différentiel + le, - le.

Les images des courants capteurs sont fournies par les miroirs de courant fournis par les transistors (T7, T20), (T18, T19), (T6, T21), (T15, T7), (T14, T19).

Le miroir (T18, T19) autorise une entrée négative sur le comparateur formé par les transistors (T7, T18). Le comparateur (T7, T18) élimine les courants de polarisation et les parasites en mode commun et permet de récupérer deux fois le courant d'entrée dans la résistance R6. La différence des deux courants effectuée par les transistors T7, T18 est transformée en tension par le transistor T9 lié, par sa base à l'anode de la diode D1 reliant la masse via la diode D2 et la résistance R6. Le condensateur C permet de mémoriser la valeur maximum atteinte. Les transistors T13, T12 forment un faux Darlington monté en suiveur et restituent dans les résistances R7 et R8 un courant fonction de l'amplitude maximum valant 2 le maximum si R7 = R8.

Les résistances R8, R11 permettent d'établir un rapport $K = \frac{R8}{R11}$ et déterminent ainsi un seuil d'inhibition fonction de l'amplitude du signal d'entrée.

La valeur de ce seuil ainsi déterminée est transmise par le miroir de courant formé des transistors T10, T11 à un point P9 formant une entrée positive d'un comparateur de courant formé des transistors (T15, T14). T15 et T14 forment aussi des miroirs de courant avec les transistors T20, T19. Le comparateur (T15, T14) reçoit ainsi sur une deuxième entrée positive et sur une entrée négative les images des courants d'entrée.

Sur l'alternance suivante, le comparateur (T15, T14), qui reçoit par P9 la fraction de courant mémorisée 2 le x $\frac{R8}{R11}$, pourra donc déterminer si un nouveau courant d'entrée 2 le a atteint la fraction de courant mémorisée.

Si c'est le cas le courant de remise il zéro IRAZ valant 2 le x $\frac{R8}{R11}$ - 2 le délivré par le comparateur (T15, T14) s'annule.

Le transistor (T16), lié par sa base au point (P8) de la ligne des collecteurs des transistors (T15) (T14), se bloque. Le transistor (T17) lié par sa base au collecteur de (T16) et à la ligne + 5V par la résistance R10 se sature. La capacité mémoire C liée au collecteur de (T17) et à la masse est remise a zéro.

L'image du courant d'inhibition mémorisée 2 le peut être injectée par le transistor T8 dans la diode D3 et être transmis sur la sortie 18, donc être appliquée au comparateur 15 pour inhiber son signal de sortie.

Mais, ceci n'est possible que si par avance l'état de sortie du comparateur 15 (fig. 1) prélevé en 19 est à l'état bas.

Si la sortie se trouve à l'état haut, avant l'établissement du courant d'inhibition, cet état porte sur la base du transistor T4, le bloque, le transistor T5 devient passant, et il interdit alors l'apparition du courant d'inhibition dans la diode D3, donc sur la sortie 18.

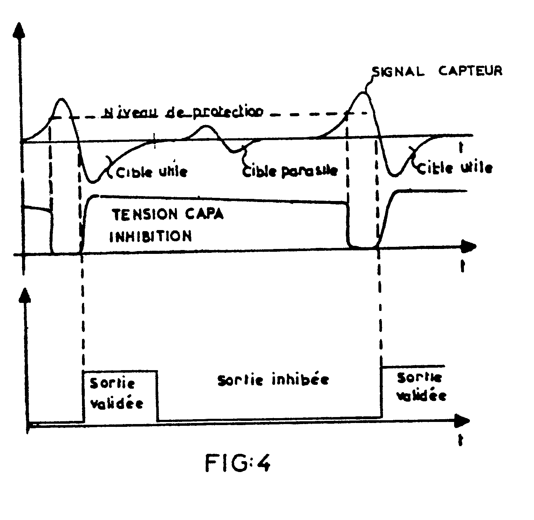

Le chronogramme de la figure 4 met en évidence le fait que l'instant de détection ou la position angulaire choisis comme référence est le passage à zéro du signal capteur, et ce quelle que soit la vitesse, l'amplification des signaux et la présence de parasites.

Ceci assure une bonne précision du signal de sortie, étant donné que le passage à zéro du signal capteur correspond au maximum de flux atteint au moment de la coïncidence de l'axe de la cible avec l'axe du capteur.

Tout autre instant de détection du signal est sujet à imprécision due à l'entrefer, la température, la dispersion des composants, la vitesse et les tolérances mécaniques.

## Revendications

1. Montage d'exploitation de signaux électriques délivrés par un capteur à réluctance variable, comportant un étage d'entrée à haute sensibilité traitant des signaux issus du capteur et ayant une amplitude fonction de la vitesse de rotation d'une pièce ou cible portée par exemple par un arbre rotatif, tel que le vilebrequin d'un moteur à combustion interne, un étage de mise en forme des signaux comportant une comparateur (15), un étage de sortié, (16) et un des dispositif d'inhibition (20) disposé parallèlement à l'étage de mise en forme des sigaux mémorisant initialement une fraction de la valeur maximale du signal d'entrée et ne validant la sortie que pour les signaux de valeur maximale supérieure à la valeur mémorisée et mémorisant alors une nouvelle valeur de l'amplitude maximum, caractérisé en ce qu le dispositif d'inhibition (20) comprend un premier moyen (21) prélevant les courants image des courants d'entrée de l'étage (14) et après élimination des courants de polarisation et de parasitage en mode commun, fournissant un signal à un deuxième moyen (C) mémorisant initialement la valeur maximale de la deuxième alternance du signal d'entrée, un troisième moyen (22) élaborant et distribuant à une entrée (E2) d'un quatrième moyen (23) une fraction (K) de la valeur mémorisée, le quatrième moyen (23) déterminant par comparaison si les amplitudes des sigaux suivants ont atteint la fraction (K) de la valeur mémorisée et permettant ou non la remise à zéro du moyen de mémorisation (C), lequel alors mémorise ou non une nouvelle valeur de l'amplitude maximum, et un cinquième moyen de commande (24) qui en fonction de la valeur mémorisée et de l'état logique de l'entrée (19) de l'étage de sortie (16) du montage (10) autorise ou non la sortie de l'information désirée par action sur l'entrée (18) du comparateur (15).

2. Montage d'exploitation de signaux électriques suivant la revendication 1, caractérisé en ce que le premier moyen (21) comporte deux transistors (T7, T18) qui sont d'une part couplés par leur collecteur et forment entre eux un comparateur (T7, T18) et sont d'autre part respectivement couplés par les bases avec deux transistors (T20, T19), montés en diode, et forment ainsi deux miroirs de courant (T7, T20), (T18, T19), et un transistor (T6) couplé par sa base avec un transistor (T21) monté en diode et formant ainsi avec (T6) un troisième miroir de courant (T6, T21).

3. Montage d'exploitation de signaux électriques suivant la revendication 1, caractérisé en ce que le deuxième moyen (C) est un condensateur lié d'une part à la masse et d'autre part au collecteur d'un transistor (T17), à l'émetteur d'un transistor (T9) et à la base d'un faux Darlington (composé des transistors (T12, T13)).

4. Montage d'exploitation de signaux électriques suivant la revendication 1, caractérisé en ce que le troisième moyen (22) comporte un transistor (T9), deux diodes (D1, D2), et une résistance (R6) formant un ensemble transformant en tension le courant différentiel donné par le comparateur (T7, T18), et de deux résistances (R11, R8) transformant en courant dans le rapport $K = \frac{R8}{R11}$ la tension fournie par l'ensemble (T9, D1, D2, R6).

5. Montage d'exploitation de signaux électriques suivant la revendication 1, caractérisé en ce que le quatrième moyen (23) comprend, deux transistors (T15, T14), liés ensemble par leur collecteur et formant un comparateur (T14, T15) et liés également et respectivement aux transistors montés en diode (T19, T20), pour former avec eux les miroirs de courant (T14, T19), (T15, T20), un transistor (T11) lié 9d'une part par son collecteur au point (P9) de la lige des collecteurs des transistors (T15, T14) et d'autre part par sa base au transistor (T10) monté en diode, ce dernier formant avec (T11) un miroir de courant, et de deux transistors (T16, T17), (T16) étant lié d'une part par sa base en (P8) à la ligne des collecteurs des transistors (T15, T14) et d'autre part par son collecteur à la base du transistor (T17) qui a son collecteur lié au condensateur (C).

6. Montage d'exploitation de signaux électriques suivant la revendication 1, caractérisé en ce que le cinquième moyen (24) comporte 3 transistors (T4, T5, T8), une diode (D3) et deux résistances (R4, R5) connectés de manière que l'état logique de l'entrée (19) polarise le transistor (T4) qui polarise à son tour la base du transistor (T5), qui suivant l'état de cette polarisation, permettra ou non au transistor (T8) de délivrer à la sortie (18) via la diode (D3) un courant d'inhibition.

**Patentansprüche**

1. Anordnung zur Auswertung elektrischer Signale, erzeugt durch einen Detektor mit variablem magnetischem Widerstand mit einer Eingangsstufe hoher Empfindlichkeit, die die vom Detektor abgegebenen Signale verarbeitet, die eine amplitude in Funktion von der Drehgeschwindigkeit eines Teils oder einer Scheibe, z. B. von einer Welle, wie z. B. der Kurbelwelle eines Verbrennungsmotors, befestigt ist, aufweist, mit einer Signalformungsstufe, die einen Vergleicher (15) aufweist, einer Ausgangsstufe (16) und einer NEIN-Schaltung (20) parallel zur Signalformungsstufe, die ursprünglich einen Teil des Maximalwertes des Eingangssignals speichert und den Ausgang nur für Signale freigibt, deren maximaler Wert größer als der gespeicherte Wert ist und die daraufhin einen neuen maximalen Amplitudenwert speichert, dadurch gekennzeichnet, daß die NEIN-Schaltung (20) ein erstes Mittel (21) aufweist, das die Ströme, die die Eingangsströme der Stufe (14) wiedergeben, aussortiert und nach der Eliminierung von Polarisationsströmen und parasitärer Ströme bekannter Art ein Signal an ein zweites Mittel (C) liefert, das ursprünglich den maximalen Wert der zweiten Halbperiode des Eingangssignals speichert, ein drittes Mittel (22), das einen Bruchteil (K) des gespeicherten Werts ausarbeitet und an einen Eingang (E2) eines vierten Mittels (23) liefert, wobei das vierte Mittel (23) durch Vergleich feststellt, ob die Amplituden der darauf folgenden Signale den Bruchteil (K) des gespeicherten Wertes erreichen und wobei das vierte Mittel die Rückstellung auf Null des Speichers (C) erlaubt oder nicht, worauf der Speicher daraufhin einen neuen maximalen Amplitudenwert speichert oder nicht speichert und ein fünftes Steuermittel (24), das in Abhängigkeit vom gespeicherten Wert und dem logischen Zustand des Eingangs (19) der Ausgangsstufe (16) der Anordnung (10) die Ausgabe der gewünschten Information mittels Betätigung des Eingangs (18) des Vergleichers (15) autorisiert oder nicht.

2. Anordnung zur Auswertung elektrischer Signale nach Anspruch 1, dadurch gekennzeichnet, daß das erste Mittel (21) zwei Transistoren (T7, T18) aufweist, die einerseits über ihre Kollektoren gekoppelt sind und untereinander einen Vergleicher (T7, T18) bilden und andererseits jeweils über die jeweiligen Basen mit zwei Transistoren (T20, T19) verbunden sind, die in Diodenschaltung verbunden sind und somit zwei Stromspiegel (T7, T20), (T18, T19), bilden und dadurch, daß ein Transistor (T6), der mit seiner Basis mit einem Transistor (T21) verbunden ist und als Diode geschaltet ist, somit mit dem Transistor (T6) einen dritten Stromspiegel (T6, T21) bildet.

3. Anordnung zur Auswertung elektrischer Signale nach Anspruch 1, dadurch gekennzeichnet, daß das zweite Mittel (C) ein Kondensator ist, der einerseits mit der Masse und andererseits mit dem Kollektor des Transistors (T17), dem Emitter eines Transistors (T9) und der Basis einer Transistorschaltung (T12, T13), die eine "faux Darlington"-Schaltung bilden, verbunden ist.

4. Anordnung zur Auswertung elektrischer Signale nach Anspruch 1, dadurch gekennzeichnet, daß das dritte Mittel (22) einen Transistor (T9), zwei Dioden (D1, D2) und einen Widerstand (R6) aufweist, die eine Anordnung bilden, die den vom Vergleicher (T7, T18) gelieferten Differenzstrom in eine Spannung umwandelt und durch zwei Widerstände (R11, R8), die von der Anordnung (T9, D1, D2, R6) gelieferte Spannung in einen Strom im Verhältnis $K = \frac{R8}{R11}$ umwandelt.

5. Anordnung zur Auswertung elektrischer Signale nach Anspruch 1, dadurch gekennzeichnet, daß das vierte Mittel (23) aufweist: zwei Transistoren (T15, T14), die über ihre Kollektoren miteinander verbunden sind und einen Vergleicher (T14, T15) bilden, die gleichermaßen jeweils mit zu Dioden verschalteten Transistoren (T19, T20) verbunden sind, um mit diesen die Stromspiegel (T14, T19), (T15, T21) zu bilden, einen Transistor (T11), der einerseits mit seinem Kollektor mit dem Punkt (P9) der Kollektorlinie der Transistoren (T14, T15) verbunden ist und andererseits über seine Basis mit dem Transistor (T10), der als Diode geschaltet ist, wobei der letztere mit dem Transistor (T11) einen Stromspiegel bildet, und zwei Transistoren (T16, T17), wobei der Transistor (T16) einerseits mit seiner Basis im Punkt (P8) mit der Kollektorlinie der Transistoren (T14, T15) verbunden ist und andererseits mit seinem Kollektor mit der Basis des Transistors (T17), dessen Kollektor an den Kondensator (C) geschaltet ist.

6. Anordnung zur Auswertung elektrischer Signale nach Anspruch 1, dadurch gekennzeichnet, daß das fünfte Mittel (24) drei Transistoren (T4, T5, T6), eine Diode (D3) und zwei Widerstände (R4, R5) aufweist, die derart miteinander verschaltet sind, daß der logische Zustand des Eingangs (19) den Transistor (T4) polarisiert, der wiederum die Basis des Transistors (T5) polarisiert, der je nach dem Polarisationszustand dem Transistor (T8) es erlaubt bzw. nicht erlaubt, an den Ausgang über die Diode (D3) einen Verhinderungsstrom zu liefern.

**Claims**

1. Arrangement for the utilisation of electrical signals delivered by a variable reluctance pickup, comprising a high-sensitivity input stage processing the signals coming from the pickup and having an amplitude which is a function of the speed of rotation of an element or target carried for example by a rotary shaft, such as the crankshaft of an internal combustion engine, a signal shaper stage comprising a comparator (15), an output stage (16) and an inhibitor device (20) arranged parallel to the signal shaper stage initially storing a fraction of the maximum value of the input signal and only validating the output for signals having a maximum value higher than the value stored and then storing another value of the maximum amplitude, characterised in that the inhibitor device (20) comprises a first means (21) sampling image currents of the input currents of the stage (14) and following the elimination of the polarisation and stray currents in a common mode, delivering a signal to a second means (C) initially storing the maximum value of the second alternation of the input signal, a third means (22) generating and distributing a fraction (K) of the stored value to an input (E2) of a fourth means (23), the fourth means (23) determining by comparison whether the amplitudes of the following signals have reached the fraction (K) of the stored value and authorising or barring the zero reset of the storage means (C), which then does or does not store a new value of the maximum amplitude, and a fifth control means (24) which as a function of the stored value and of the logic state of the input (19) of the output stage (16) of the arrangement (10) authorises or bars the output of the required information by action on the input (18) of the comparator (15).

2. Arrangement for the utilisation of electrical signals according to claim 1, characterised in that the first means (21) comprises two transistors (T7, T18) which are coupled on the one hand via their collectors and between them form a comparator (T7, T18) and on the other hand are coupled respectively via the bases to two transistors (T20,T19) arranged in diode connection, and thus form two current reflectors (T7, T20), (T18, T19), and a transistor (T6) coupled via its base to a transistor (T21) arranged in diode connection and thus forming with (T6) a third current reflector (T6, T21).

3. Arrangement for the utilisation of electrical signals according to claim 1, characterised in that the second means (C) is a capacitor connected on the one hand to earth and on the other hand to the collector of a transistor (T17), to the emitter of a transistor (T9) and to the base of a false Darlington circuit (formed by the transistors (T12, T13)).

4. Arrangement for the utilisation of electrical signals according to claim 1, characterised in that the third means (22) comprises a transistor (T9), two diodes (D1, D2), and a resistor (R6) forming an assembly transforming the differential current provided by the comparator (T7, T18) into a voltage, and two resistors (R11, R8) transforming the voltage supplied by the assembly (T9, D1, D2, R6) into current in the ratio $K = \frac{R8}{R11}$.

5. Arrangement for the utilisation of electrical signals according to claim 1, characterised in that the fourth means (23) comprises two transistors (T15, T14) connected together via their collectors and forming a comparator (T14, T15) and equally and respectively connected to the transistors (T19, T20) arranged in diode connection to form with them the current reflectors (T14, T19), (T15, T20), a transistor (T11) connected on the one hand via its collector to the point (P9) of the line of collectors of the transistors (T15, T14) and on the other hand via its base to the transistor (T10) arranged in diode connection, this latter with (T11) forming a current reflector, and two transistors (T16, T17), (T16) being connected on the one hand via its base at (P8) to the line of collectors of the transistors (T15, T14) and on the other hand via its collector to the base of the transistor (T17) which has its collector connected to the capacitor (C).

6. Arrangement for the utilisation of electrical signals according to claim 1, characterised in that the fifth means (24) comprises 3 transistors (T4, T5, T8), a diode (D3) and two resistors (R4, R5) connected in such a manner that the logic state of the input (19) biases the transistor (T4) which for its part biases the base of the transistor (T5) which as a function of the state of this bias will or will not authorise the transistor (T8) to supply an inhibiting current to the output (18) via the diode (D3).

FIG 1

FIG 2

0 117 789

FIG. 3

FIG:4